# DEMANDE DE BREVET EUROPEEN

(11) **EP 0 802 626 A1**
(43) Date de publication de la demande: **22.10.1997**
(21) Numéro de dépôt: 97400747.8
(22) Date de dépôt: 01.04.1997
(51) Int. Cl.: H03F 3/60, H03F 1/30

(54) **Amplificateur distribué large bande en fréquence et à compensation thermique**

(30) Priorité: 17.04.1996 FR 9604800
(71) Demandeur: DASSAULT ELECTRONIQUE, F-92210 Saint-Cloud (FR)
(72) Inventeur: Aperce, Gilles, 78120 Rambouillet (FR); Decaesteke, Thierry, 78650 Beynes (FR)
(74) Mandataire: Nicolle, Olivier

(57) **Abrégé**

Les moyens de polarisation de la ligne de grilles comprennent un premier circuit (100) propre à délivrer un premier potentiel choisi (VGlA) à une première extrémité (15) de la ligne de grilles, ledit premier potentiel étant proportionnel à la différence de potentiel entre un potentiel de référence fixe (VG0) et un potentiel variable en fonction de la température courante de l'amplificateur (VC(T)), et un second circuit (200) propre à délivrer un second potentiel choisi (VG1B) à une seconde extrémité de la ligne de grilles, ledit second potentiel (VG1B) étant proportionnel à la somme du potentiel de référence fixe (VG0) et du potentiel variable (VC(T)) en fonction de la température courante de l'amplificateur, ce qui permet de compenser en température la tension de polarisation de la ligne de grilles.

## Description

La présente invention concerne un amplificateur distribué large bande en fréquence et à compensation thermique.

Elle trouve une application générale en micro-électronique, et plus particulièrement dans la fabrication de composants en technologie monolithique micro-ondes ou hyperfréquence.

On connaît déjà des amplificateurs distribués large bande en fréquence.

D'une manière générale, ils comprennent :
- au moins une ligne de drains;
- au moins une ligne de grilles;
- une pluralité de cellules amplificatrices comprenant chacune au moins un transistor à effet de champ monté en source commune dont la grille et le drain sont reliés respectivement à un point de la ligne de grilles et à un point de la ligne de drains;
- des moyens de polarisation de la ligne de grilles; et
- des moyens de polarisation de la ligne de drains.

Le gain de ce genre d'amplificateur distribué n'est pas constant sur une large bande de fréquences, quelles que soient les conditions extérieures de fonctionnement de l'amplificateur, dans la mesure où certaines caractéristiques des transistors à effet de champ, qui constituent la partie active des cellules amplificatrices, varient en fonction de la température.

Pour maintenir constant ce gain, quelle que soit la température des transistors et sur une bande de fréquences allant par exemple de 2 à 20 GHz, il est jusqu'à présent nécessaire de réduire la puissance de sortie de l'amplificateur, et d'augmenter le taux des harmoniques, ainsi que la consommation en courant pour la polarisation de la ligne de drains.

La présente invention remédie à ces inconvénients.

Ainsi, elle vise à fournir un amplificateur distribué à large bande de fréquences, avec un gain constant quelle que soit la température des transistors, par exemple allant de -40°C à +100°C.

Elle porte sur un amplificateur distribué du type mentionné ci-avant.

Selon une définition générale de l'invention, les moyens de polarisation de la ligne de grilles comprennent :
- un premier circuit propre à délivrer un premier potentiel choisi à une première extrémité de la ligne de grilles, ledit premier potentiel étant proportionnel à la différence de potentiel entre un potentiel de référence fixe et un potentiel variable en fonction de la température courante de l'amplificateur; et
- un second circuit propre à délivrer un second potentiel choisi à une seconde extrémité de la ligne de grilles, ledit second potentiel étant proportionnel à la somme du potentiel de référence fixe et du potentiel variable en fonction de la température courante de l'amplificateur,
ce qui permet de compenser en température la tension de polarisation de la ligne de grilles.

En pratique, le premier circuit comprend un premier amplificateur différentiel, monté en inverseur, et possédant une entrée non inverseuse recevant le potentiel de référence fixe, une entrée inverseuse recevant le potentiel variable, et une sortie appliquée à la première extrémité de la ligne de grilles; et un premier réseau de résistances branché de manière appropriée sur les entrées et sortie du premier amplificateur différentiel de telle sorte que le gain du premier amplificateur différentiel soit négatif.

De même, le second circuit comprend un second amplificateur différentiel monté en non inverseur, et possédant une entrée non inverseuse recevant le potentiel de référence fixe, et le potentiel variable, et une sortie appliquée à la seconde extrémité de la ligne de grilles; et un second réseau de résistances branché de manière appropriée sur les entrées et sortie du second amplificateur différentiel de telle sorte que le gain du second amplificateur différentiel soit positif.

Avantageusement, l'amplificateur distribué comprend en outre une capacité de découplage disposée entre les première et seconde extrémités de la ligne de grilles, afin de découpler les premier et second potentiels des signaux hyperfréquences.

D'autres caractéristiques et avantages de l'invention apparaîtront à la lumière de la description détaillée ci-après, et des dessins dans lesquels :
- la figure 1 représente schématiquement un amplificateur distribué hyperfréquence de l'art antérieur;
- la figure 2 représente des courbes illustrant le gain de l'amplificateur de la figure 1 en fonction de la fréquence pour des températures de -40°C, +25°C et +100°C;
- la figure 3 représente schématiquement un amplificateur distribué hyperfréquence à compensation thermique selon l'invention;
- la figure 4 représente schématiquement les circuits de polarisation de la ligne de grilles de l'amplificateur à compensation thermique selon l'invention;
- la figure 5 représente des courbes pour des températures -40°C, +25°C et +100°C, illustrant le gain d'un amplificateur distribué en fonction de la tension de polarisation de la ligne de grilles, à une fréquence de 2GHz; et
- la figure 6 représente des courbes pour des températures de -40°C, +25°C et +100°C illustrant le gain de l'amplificateur en fonction de la fréquence selon l'invention.

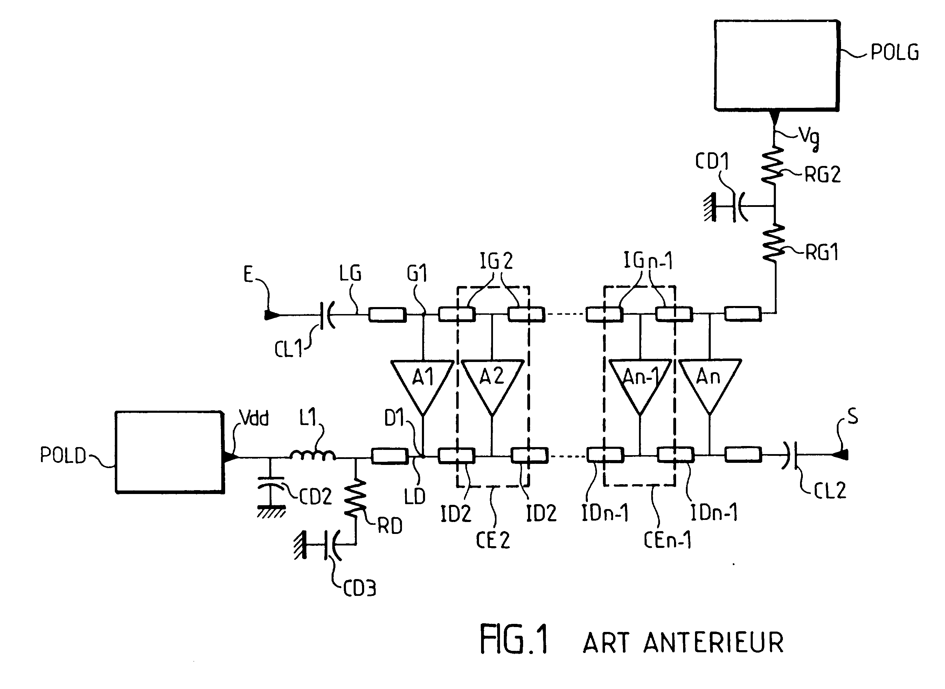

Sur la figure 1, un amplificateur distribué à large bande de fréquences de l'art antérieur comprend n cellules amplificatrices CE montées entre une ligne de grilles LG et une ligne de drains LD. Chaque cellule CE individualisée en CE1 à CEn comporte une structure amplificatrice A individualisée en A1 à An. Un ou plusieurs transistors à effet de champ constituent la partie active de chaque structure amplificatrice. Le plus souvent, cette partie active est constituée d'un transistor à effet de champ monté en source commune et dont la grille et le drain sont respectivement reliés en un point de la ligne de grilles et en un point de la ligne de drains.

Chaque cellule amplificatrice est complétée par des éléments passifs servant à constituer des équivalents de tronçons de la ligne de drains ID et de la ligne de grilles IG. Par exemple, ces éléments passifs sont constitués d'inductances IG2 et ID2 pour la cellule CE2.

La tête de la ligne de grilles LG forme l'entrée E de l'amplificateur distribué. L'autre extrémité de la ligne de grilles est chargée sur une résistance terminale RG qui est sensiblement égale à l'impédance caractéristique de la ligne de grilles. En pratique, la résistance terminale RG comprend deux résistances RG1 et RG2 montées en série et de 50 ohms chacune.

Inversement, l'une des extrémités de la ligne de drains LD est chargée sur une résistance terminale RD sensiblement égale à l'impédance caractéristique de la ligne de drains, tandis que l'autre extrémité de la ligne de drains définit la sortie S de l'amplificateur distribué.

Des premiers moyens de polarisation POLG appliquent une tension de polarisation à la ligne de grilles LG à travers la résistance terminale RG.

De même, des seconds moyens de polarisation POLD appliquent une tension de polarisation VDD à la ligne de drains LD à travers avantageusement une self L1.

De manière connue, des capacités de liaison CL1 et CL2 sont prévues respectivement entre l'entrée de l'amplificateur et la tête de la ligne de grilles LG, et entre l'extrémité de la ligne de drains LD et la sortie S de l'amplificateur distribué.

De même, une capacité de découplage CD1 est prévue pour découpler la tension de polarisation continue VG des signaux hyperfréquences. Cette capacité de découplage CD1 comprend une armature à la masse et une autre armature reliée à une borne de la résistance RG.

De même, une capacité de découplage CD2 est prévue pour découpler la tension de polarisation VDD des signaux hyperfréquences. Cette capacité de découplage CD2 comprend une armature mise à la masse et une autre armature reliée à une borne de la self L1.

Enfin, une capacité de découplage CD3 est également prévue avec une armature mise à la masse et une autre armature reliée à une borne de la résistance terminale RD.

Le principe de fonctionnement de l'amplificateur distribué de la figure 1 est le suivant.

Le signal d'entrée se propage sur la ligne de grilles LG. Chaque structure amplificatrice, par exemple la structure A1 reçoit en son point G1 et fournit à la ligne de drains en son point D1 une version amplifiée du signal d'entrée, version qui se propage sur cette ligne de drains LD.

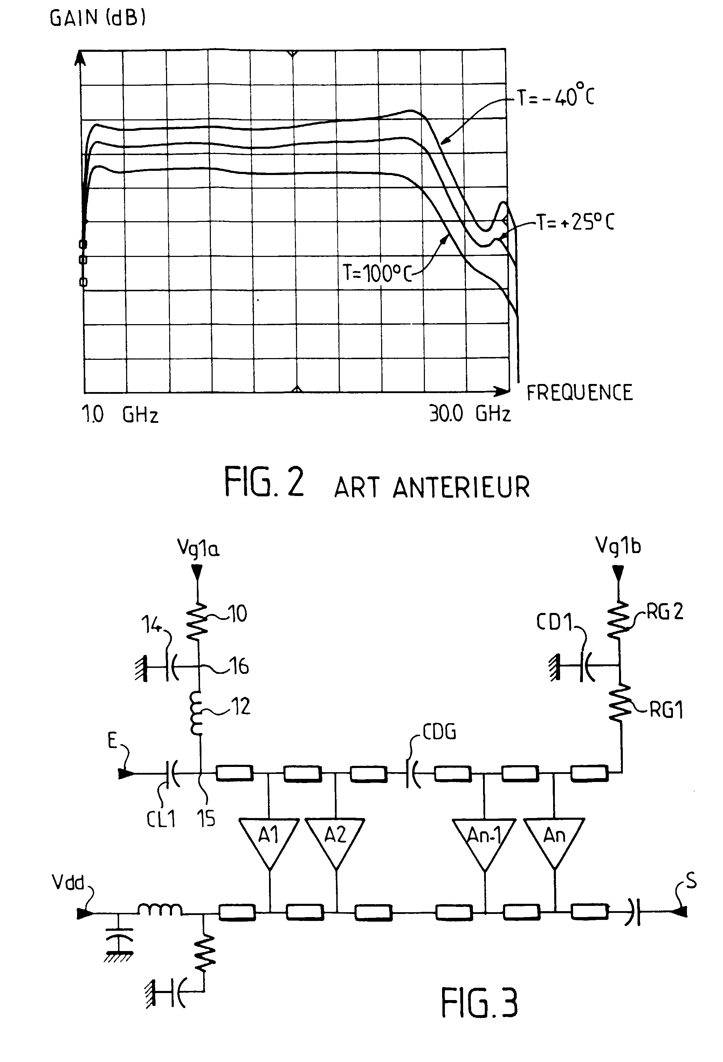

En référence à la figure 2, on voit que le gain de l'amplificateur distribué de la figure 1 en fonction de la fréquence allant de 1 à 30 GHz, est différent selon la température de l'amplificateur. Ainsi, le gain à -40°C est plus élevé que celui obtenu à +25°C, lui-même plus élevé que celui obtenu à +100°C.

La Demanderesse s'est posé le problème d'apporter une compensation thermique à l'amplificateur distribué hyperfréquence décrit en référence à la figure 1, afin d'obtenir un gain constant sur toute la bande de fréquences, quelle que soit la température des transistors constituant l'amplificateur distribué, en conservant la même puissance de sortie de l'amplificateur, le même taux des harmoniques et la même consommation en courant de la polarisation de la ligne de drains.

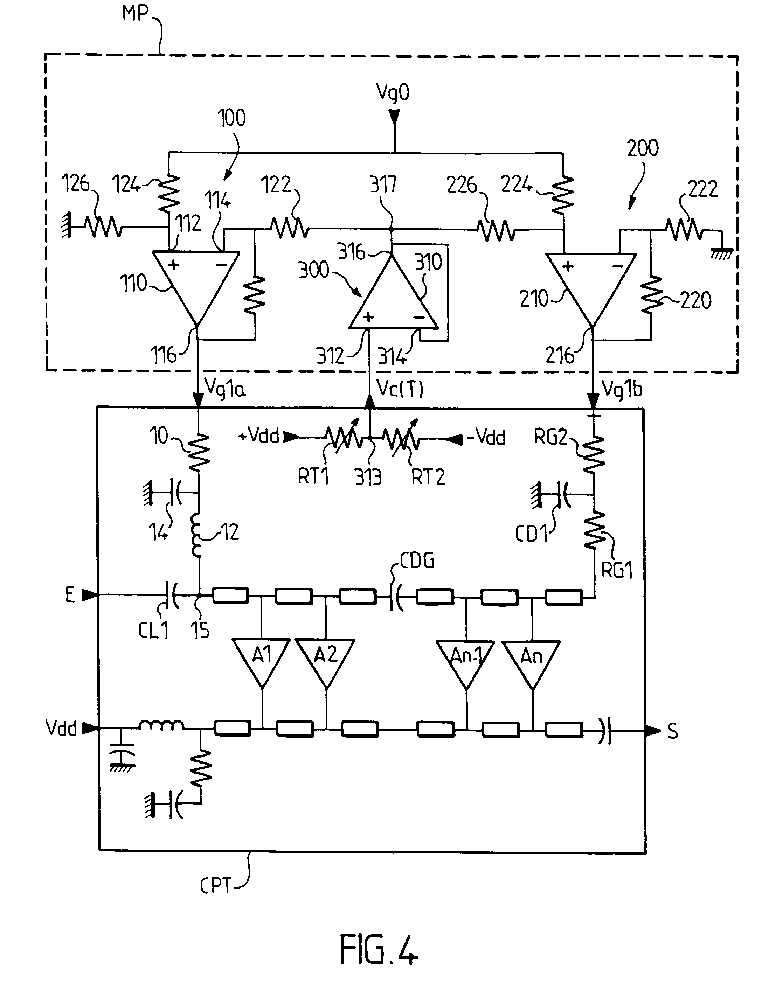

La solution proposée selon la présente invention consiste, en référence à la figure 3, à effectuer notamment les modifications suivantes par rapport à l'amplificateur distribué décrit en référence à la figure 1.

Tout d'abord, il est prévu d'appliquer sur la ligne de grilles plusieurs tensions de polarisation de grille distinctes afin de compenser la dispersion thermique des transistors constituant les cellules amplificatrices de l'amplificateur distribué.

Par exemple, ces tensions de polarisation distinctes sont représentées sur la figure 3 par les références VG1A et VG1B.

Ici, VG1B correspond à la tension VG appliquée à l'amplificateur distribué décrit en référence à la figure 1.

Par contre, la tension VG1A est appliquée à l'autre extrémité de la ligne de grilles à travers un réseau de résistance, inductance et capacité destiné à découpler cette tension de polarisation continue des signaux hyperfréquences.

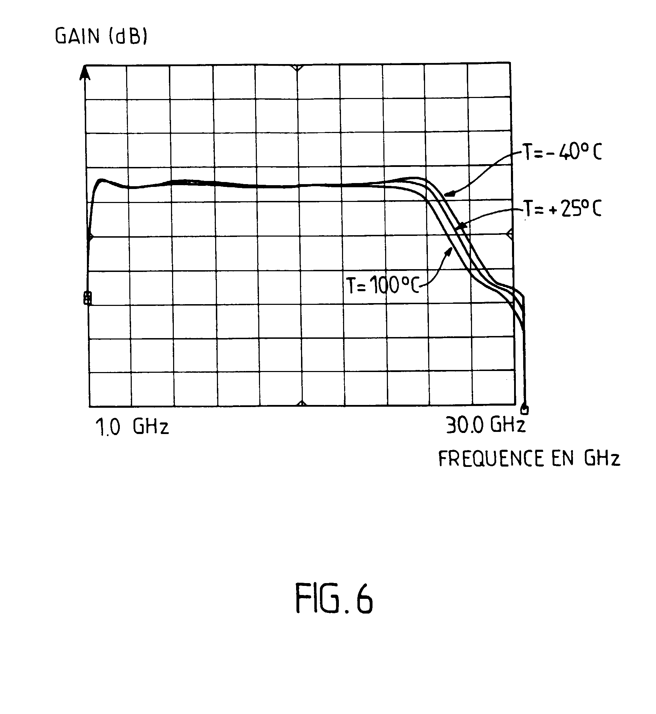

Ensuite, il est prévu de choisir de manière appropriée les valeurs des tensions VG1A et VG1B de telle sorte que le gain de l'amplificateur distribué soit sensiblement constant sur toute la bande de fréquences, par exemple allant de 1 GHz à 20 GHz, quelle que soit la température dans une plage de températures allant par exemple de -40°C à +100°C (figure 6).

Enfin, il est prévu une capacité de découplage CDG disposée entre les première et seconde extrémités de la ligne de grilles LG afin de découpler les tensions de polarisation de grilles continues des signaux hyperfréquences. Avantageusement, cette capacité de découplage CDG est disposée sensiblement à la moitié de la ligne de grilles LG.

De manière connue, le réseau de résistance, inductance et capacité à travers lequel est appliquée la tension VG1A est articulé de la façon suivante. Il comprend une résistance 10 et une inductance 12 montées en série et appliquées au point 15 de la ligne de grilles LG. Une armature de la capacité 14 est mise à la masse, tandis que l'autre armature de la capacité 14 est reliée au point commun 16 d'une borne de la résistance 10 et d'une borne de l'inductance 12.

En référence à la figure 4, les moyens de polarisation MP de la ligne de grilles capables de délivrer les tensions VG1A et VG1B sont disposés à proximité de l'amplificateur distribué décrit en référence à la figure 3. En pratique, ces moyens de polarisation MP ne sont pas intégrés directement sur le même composant que l'amplificateur, dont le contour en référence à la figure 4 est désigné par la référence CPT. Avantageusement, la technologie utilisée pour le composant regroupant toutes les fonctions contenues dans le contour CPT est la technologie de circuit intégré monolithique hyperfréquence appelée encore MMIC pour "Microwave Monolithic Integrated Circuit".

Les moyens de polarisation de la ligne de grilles non intégrés sur le composant CPT comprennent au moins deux circuits 100 et 200 propres à délivrer la tension VG1A d'une part et la tension VG1B d'autre part.

Le circuit 100 est monté en inverseur et délivre la tension VG1A à une première extrémité 15 de la ligne de grilles. Ce potentiel VG1A est proportionnel à la différence de potentiel entre un potentiel de référence fixe VG0 et un potentiel variable en fonction de la température courante de l'amplificateur VC(T).

Le circuit 200 est monté en non inverseur, et délivre le potentiel VG1B à l'autre extrémité de la ligne de grilles.

Le potentiel VG1B est proportionnel à la somme du potentiel de référence fixe VG0 et du potentiel variable en fonction de la température courante de l'amplificateur VC(T).

Plus précisément, le circuit 100 comprend un premier amplificateur différentiel 110, monté en inverseur et possédant une entrée non inverseuse 112 recevant le potentiel de référence fixe VGO, une entrée inverseuse 114 recevant le potentiel variable VC(T), et une sortie 116 appliquée à l'extrémité 15 de la ligne de grilles LG à travers le réseau résistance 10, inductance 12 et capacité 14.

Un réseau de résistances 120, 122, 124, 126 est branché sur les entrées et sortie de l'amplificateur différentiel 110 de telle sorte que le gain k de l'amplificateur différentiel 110 soit négatif et égal à -k.

Le circuit 200 comprend un amplificateur différentiel 210 monté en non inverseur et possédant une entrée non inverseuse 212 recevant le potentiel de référence fixe VG0 et le potentiel variable VC(T), et une sortie 216 appliquée à la seconde extrémité de la ligne de grilles LG.

Un réseau de résistances 220, 222, 224 et 226 est branché de manière appropriée sur les entrées et sortie de l'amplificateur 210 de telle sorte que le gain m du second amplificateur différentiel soit positif et égal à +m.

En pratique, les amplificateurs différentiels 110 et 210 sont ceux vendus par la Société National Semiconductor sous la référence LM148/LM149 series QUAD 741 OP AMP.

Le potentiel de référence fixe VG0 est par exemple délivré par une alimentation continue spécifique capable de délivrer une tension -5/+5 Volts. Ce potentiel VG0 est appliqué à l'entrée 112 à travers une résistance 124 d'une valeur résistive 1 kiloohm. Le potentiel VG0 est appliqué à l'entrée 212 de l'amplificateur différentiel 210 à travers une résistance 224 d'une valeur ohmique 1 kiloohm.

La résistance 126 dont une borne est mise à la masse et dont l'autre borne est reliée à l'entrée 112 a une valeur ohmique 1 kiloohm.

La résistance 222 dont une borne est mise à la masse et dont l'autre borne est reliée à l'entrée 214 a une valeur ohmique 1 kiloohm.

La résistance 120 dont une borne est reliée à l'entrée 114 et dont l'autre borne est reliée à la sortie 116 a une valeur ohmique 1 kiloohm.

La résistance 220 dont une borne est reliée à l'entrée 214 et dont l'autre borne est reliée à la sortie 216 a une valeur ohmique 1 kiloohm.

Le potentiel VG0 a une valeur égale à 0,3 volt.

Le potentiel variable en fonction de la température VC(T) est élaboré à l'aide des thermistances RT1 et RT2 avantageusement intégrées dans le composant CPT et recevant respectivement un potentiel fixe positif et un potentiel fixe négatif.

Par exemple, le potentiel fixe positif est égal à +VDD et le potentiel fixe négatif est égal à -VDD.

Avantageusement, il est prévu en outre un circuit 300 monté en suiveur de tension pour éviter de perturber le réseau sur lequel il est branché et éviter que le choix des valeurs ohmiques des résistances des circuits 100 et 200 soit critique. Ce circuit 300 comprend un amplificateur différentiel 310, monté en suiveur de tension, et possédant une entrée non inverseuse 312 reliée au point commun 313 des résistances RT1 et RT2, une entrée inverseuse 314, et une sortie 316 reliée à l'entrée 314 et au point commun 317 des résistances 122 et 226.

Selon l'invention, avec un potentiel VDD égal à 5 volts, il est possible de balayer une plage de températures allant de -40°C à +100°C en choisissant de manière appropriée les valeurs RT1 et RT2.

Par exemple, pour une température de -40°C, le potentiel VC(T) est égal à -0,25 volt.

Ce potentiel VC(T) est appliqué à l'entrée 114 à travers la résistance 122 ayant une valeur ohmique 1 kiloohm.

De même, ce potentiel VC(T) est appliqué à l'entrée 212 à travers une résistance 226 ayant une valeur ohmique 1 kiloohm.

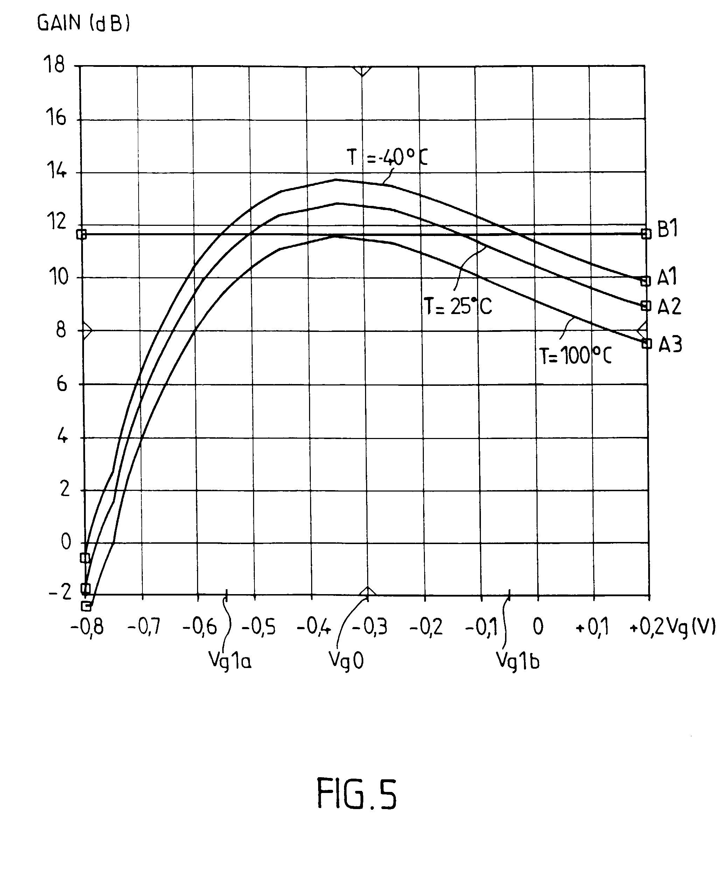

En référence à la figure 5, on a représenté le gain en décibels d'un amplificateur distribué en fonction de la tension de polarisation de la ligne de grilles en volts, à une fréquence de 2 GHz.

Apparaissent en tout trois courbes individualisées en A1, A2 et A3. La courbe A1 est représentative du gain de l'amplificateur distribué obtenu à une température de -40°C. La courbe A2 illustre le gain de l'amplificateur distribué à une température +25°C. La courbe A3 illustre le gain de l'amplificateur distribué à une température de +100°C.

La droite B1 illustre un gain constant, ici autour de 11,8 dB, en dessous duquel l'amplificateur distribué sur toute la bande de fréquences 2-20 GHz ne doit pas descendre quelle que soit la température entre -40°C et +100°C.

En prenant la température extrême -40°C, il apparaît que, pour ne pas descendre en-deçà du gain de 11,8 dB, le potentiel VG1A est égal à 0,55 volt et le potentiel VG1B est égal à -0,05 volt.

Pour la température extrême 100°C, les potentiels VG1A et VG1B sont égaux à -0,3 volt.

Enfin, le potentiel fixe VG0 est égal à -0,3 volt.

En présence de ces valeurs numériques, il apparaît que les gains k et m sont égaux à environ 1.

Un tel aménagement selon l'invention permet d'obtenir un gain constant pour l'amplificateur distribué sur toute la bande de fréquences allant de 2 GHz à 20 GHz quelle que soit la température courante de l'amplificateur allant de -40°C jusqu'à +100°C.

Une telle structure a l'avantage de conférer notamment une amélioration de la puissance de sortie ainsi qu'une réduction du taux des harmoniques et de la consommation en courant par rapport aux structures antérieures.

## Revendications

1. Amplificateur distribué large bande en fréquence comprenant :
- au moins une ligne de drains (LD);
- au moins une ligne de grilles (LG);
- une pluralité de cellules amplificatrices (A) comprenant chacune au moins un transistor à effet de champ monté en source commune, dont la grille et le drain sont reliés respectivement à un point de la ligne de grilles et à un point de la ligne de drains;
- des moyens de polarisation de la ligne de grilles; et
- des moyens de polarisation de la ligne de drains,
caractérisé en ce que les moyens de polarisation de la ligne de grilles comprennent :
- un premier circuit (100) propre à délivrer un premier potentiel choisi (VG1A) à une première extrémité (15) de la ligne de grilles, ledit premier potentiel étant proportionnel à la différence de potentiel entre un potentiel de référence fixe (VG0) et un potentiel variable en fonction de la température courante de l'amplificateur (VC(T)); et
- un second circuit (200) propre à délivrer un second potentiel choisi (VG1B) à une seconde extrémité de la ligne de grilles, ledit second potentiel (VG1B) étant proportionnel à la somme du potentiel de référence fixe (VG0) et du potentiel variable (VC(T)) en fonction de la température courante de l'amplificateur,
ce qui permet de compenser en température la tension de polarisation de la ligne de grilles.

2. Amplificateur selon la revendication 1, caractérisé en ce que le premier circuit (100) comprend :
- un premier amplificateur différentiel (110), monté en inverseur, et possédant une entrée non inverseuse (112) recevant le potentiel de référence fixe (VG0), une entrée inverseuse (114) recevant le potentiel variable (VC(T)), et une sortie (116) appliquée à la première extrémité de la ligne de grilles; et
- un premier réseau de résistances (120, 122, 124, 126) branché de manière appropriée sur les entrées et sortie du premier amplificateur différentiel de telle sorte que le gain (k) du premier amplificateur différentiel soit négatif.

3. Amplificateur selon la revendication 1, caractérisé en ce que le second circuit (200) comprend :
- un second amplificateur différentiel (210), monté en non inverseur, et possédant une entrée non inverseuse (212) recevant le potentiel de référence fixe (VG0), et le potentiel variable (VC(T)), une entrée inverseuse (214) et une sortie (216) appliquée à la seconde extrémité de la ligne de grilles; et
- un second réseau de résistances (220, 222, 224 et 226) branché de manière appropriée sur les entrées et sortie du second amplificateur différentiel (210) de telle sorte que le gain (m) du second amplificateur différentiel soit positif.

4. Amplificateur selon la revendication 1, caractérisé en ce qu'il comprend en outre une capacité de découplage (CDG) disposée entre les première et seconde extrémités de la ligne de grilles.

5. Amplificateur selon l'une quelconque des précédentes revendications, caractérisé en ce qu'il est réalisé au moins en partie en technologie de circuit intégré monolithique hyperfréquence.
